# EUROPEAN PATENT APPLICATION

(11) **EP 3 633 081 A1**
(43) Date of publication of application: **08.04.2020**
(21) Application number: 18809748.9
(22) Date of filing: 06.02.2018
(51) Int. Cl.: C30B 29/28, C30B 15/04, C30B 33/02, C09K 11/55, C09K 11/78, C09K 11/80, G01T 1/202

(54) **SINGLE CRYSTAL WITH GARNET STRUCTURE FOR SCINTILLATION COUNTERS AND METHOD FOR PRODUCING SAME**

(30) Priority: 02.06.2017 RU 2017119423
(71) Applicant: Otkrytoe Aktsionernoe Obschestvo "Fomos-Materials", Moscow 107023 (RU)
(72) Inventor: ALENKOV, Vladimir Vladimirovich, Podolsk, Moskovskaya obl. 142114 (RU); BUZANOV, Oleg Alekseevich, Moscow 117593 (RU); DOSOVITSKY, Aleksei Efimovich, Moscow 117647 (RU); DOSOVITSKY, Georgy Alekseevich, Moscow 125464 (RU); KORJIK, Mikhail Vasilievich, Minsk 220020 (BY); FEDOROV, Andrei Anatolievich, Minsk 220093 (BY)
(74) Representative: Hoffmann Eitle
(86) International application number: PCT/RU2018/000066
(87) International publication number: WO 2018/222078

(57) **Abstract**

The invention relates to scintillation inorganic oxide single crystals with garnet structure, which comprise cerium and are co-alloyed with titanium and Group 2 elements. The invention makes it possible to increase the scintillation output and to enhance the energy resolution of scintillation detectors during gamma-ray quantum registration. The technical result is achieved by a single crystal with a garnet structure being co-alloyed with cerium, titanium and Group 2 elements. This single crystal is produced by the Czochralski process.

## Description

The invention relates to scintillation single crystals with garnet structure, namely, to inorganic single crystals doped with ions of rare-earth element cerium Ce, in which, under the effect of ionized radiation, light flashes of scintillations arise, and intended for ionizing radiation detectors in tasks of medical diagnostics, ecological monitoring, non-destructive testing and mineral prospecting, experimental physics, devices for measurement in outer space. The invention also relates to the technology of producing scintillation single crystals with garnet structure co-alloyed with ions of Group 2 elements Mg Ca, Sr, Ba and ions of titanium Ti for modification of scintillation properties of single crystal.

Luminophores are used for conversion of energy of various kinds into light energy. Scintillators are luminophores, in which short-term light flashes - scintillations (flashes of luminescence) arise under the action of ionizing radiation. Atoms or molecules of the scintillator go, due to the energy of charged particles, into an excited state, and the subsequent transition from the excited to the normal state is accompanied by emission of light - scintillation. The mechanism of scintillation, its radiation spectrum and duration of luminescence depend on the nature of the material.

The emitted number of photons is proportional to the absorbed energy, which allows to obtain energy spectra of radiation. In a scintillation detector, the light emitted during scintillation is collected on a photodetector, converted into an electrical signal, which is amplified and recorded by a particular recording system. The luminescence spectrum of the scintillation material must be optimally matched to the spectral sensitivity of the photodetector used. If inconsistent with the spectral sensitivity of the detector, the spectrum of luminescence of the scintillation material degrades the energy resolution of the scintillation detector.

The luminescence of the scintillator can be due to both the properties of the base material and the presence of an admixture - dopant. Scintillators that glow without a dope are referred to as being self-activated. To increase the light output, i.e. the number of photons emitted by the scintillator when absorbing a certain amount of energy, a so-called dopant is introduced into the crystal. The dopant forms centers of luminescence in the base material (base).

Crystal scintillators are characterized by the following properties: wavelength (λₘₐₓ), which corresponds to the maximum of the luminescence spectrum; the scintillator transparency range in the wavelength region (λₘₐₓ); luminescence time constant (τ); density; effective atomic number (Z_{eff}); operating temperature; refractive index; light output.

A scintillation detector is a device for recording ionizing radiation and elementary particles (protons, neutrons, electrons, γ-ray quanta, etc.), the main elements of which are a material luminescent under the action of charged particles (scintillator) and a photodetector. Detection of neutral particles (neutrons, γ-quanta) occurs by secondary charged particles formed by the interaction of neutrons and γ-ray quanta with the scintillator atoms.

Materials with high density and high effective atomic number are used for spectrometry of y-ray quanta and high energy electrons. The efficiency of gamma-ray quanta registration is determined by the density of the substance and the effective charge of the compound Z_{eff} (see LECOQ P. et al, Inorganic Scintillators for Detector Systems, 2017, p.40), and that of neutrons - by their absorption cross-section. The scintillation output determines the energy resolution during registration of gamma-ray quanta and neutrons. Together, the registration efficiency and the energy resolution determine the possibility and the scope of application of a scintillation material for the registration of ionizing radiation.

There are known self-activated scintillation single crystals of Bi₄Ge₃O₁₂, CdWO₄, PbWO₄, which have a high efficiency of ionizing radiation registration, however, crystals of Bi₄Ge₃O₁₂, CdWO₄ have slowly decaying scintillations, while crystals of PbWO₄ have a low scintillation output (US 7279120 B2, 09.10.2007, RU 2031987 C1, 27.03.1995, as well as RU 2132417 C1, 27.06.1999). To increase the light output, the self-activated scintillation crystal is cooled, which works well in such type of crystals, whose structural units (oxy-anion complexes) have significantly temperature-quenched luminescence. In PbWO₄ crystals, cooling to a temperature of minus 25°C allows its light output to triple, while maintaining a short luminescence time, but this does not provide an acceptable energy resolution at registration of gamma-ray quanta in the energy range of less than 1 MeV, which makes them unsuitable for use in medical diagnostic devices.

The greatest variety of parameters can be obtained from crystal phosphors, by varying the dopants and the composition of the base (WO 2001060945 A2, 23.08.2001). There are known scintillation single crystals doped with cerium Ce ions (the dopant content in the crystal matrix is at the level of tenths of a percent), which have one of the largest scintillation outputs (see, e.g., US 7250609 B2, 31.07.2017). Scintillation materials doped with cerium ions have, in addition to high scintillation output, a short luminescence time. Among the scintillation crystals doped with cerium ions, there are materials with a garnet structure possessing a cubic spatial symmetry group. These crystals are the most technologically advanced, allowing to obtain a wide range of compositions for use in scintillation detectors.

Unlike self-activated scintillation crystals, the luminescence of a scintillation single crystal doped with cerium ions is due to inter-configuration d-f luminescence having a high quantum output and a negligible quenching effect near room temperature. In crystals doped with cerium, there occurs no increase of light output with a decrease in the temperature of the crystal. Moreover, some of the cerium-doped oxide scintillators, especially perovskites such as YAlO₃, LuAlO₃ and their solid solutions, show a 10-20% decrease in light output when the temperature drops from room values to minus 20°C.

Unlike self-activated scintillators, in scintillators based on cerium-doped crystals, the kinetics of scintillations is weakly dependent on temperature when the temperature deviates from room temperature in the range of +/- 50°C. However, as the temperature decreases, small electron traps formed in crystals based on point defects provide additional slow components in scintillation, as well as phosphorescence, which leads to an increase in the afterglow level in the crystal.

Using rare-earth ions to form the crystal matrix of scintillation materials such as lutetium and gadolinium enables creating high-density materials, for example Gd₂SiO₅, Lu₂SiO₅, Lu₃Al₅O₁₂, and when those are doped with cerium Ce ions, it is possible to combine high material density and high scintillation output, over 10,000 photons per 1 MeV. However, lutetium-based materials have natural radioactivity, which limits their use in some cases. The crystal of Gd₂SiO₅ has the lowest scintillation output among the above materials.

An increase in the scintillation output in inorganic gadolinium-based materials is achieved in mixed garnets (based on gadolinium ions, aluminum ions and gallium) when the compound is doped with cerium ions (WO 2012105202 A1, 09.08.2012). US 20150353822 A1, 10.12.2015 discloses a scintillation single crystal of Gd₃Ga₃Al₂O₁₂ for radiation detectors and a method for obtaining the same by co-alloying with admixtures. Known materials have a high scintillation output and can be used for registration of γ-ray quanta and neutrons.

Natural gadolinium is a mixture of six stable isotopes, ¹⁵⁴Gd (2.18%), ¹⁵⁵Gd (14.8%), ¹⁵⁶Gd (20.5%), ¹⁵⁷Gd (15.7%), ¹⁵⁸Gd (24.8%) 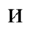 ¹⁶⁰Gd (21.9%), with two of them, 155Gd and 157Gd, having the highest thermal neutron capture cross section of all known stable isotopes, 61,000 and 254,000 barn, respectively. Neutron capture is accompanied by the emission of γ-ray quanta with a total energy of about 8 MeV:

n+¹⁵⁵Gd→¹⁵⁶Gd+γ (8.5 MeV)

n+¹⁵⁷Gd→¹⁵⁸Gd+γ (7.9 MeV).

The highest output among the emitted γ-ray quanta due to the interaction is shown by quanta with an energy of 76 keV and 179 keV. This energy release, as well as individual γ-ray quanta, can be registered by the same crystal in which the interaction occurs. Thus, the known material can expand the possibilities for neutron registration in a wide energy range of neutrons.

However, the complex composition and structure of the known scintillation crystal, including gadolinium, gallium and aluminum ions, for example, Gd₃Ga₃Al₂O₁₂, as well as the tendency of one of the main components - gallium - to evaporate from the melt, predetermine an increased concentration of defects, in particular oxygen vacancies (see Lamoreaux R H., et all. "High Temperature Vaporization Behavior of Oxides II. Oxides of Be, Mg, Ca, Sr, Ba, B, Al, Ga, In, Tl, Si, Ge, Sn, Pb, Zn, Cd, and Hg" J. Phys. Chem. Ref, 1987, data 16 419-43). Oxygen vacancies are electron capture centers, which causes phosphorescence in the scintillation material due to tunneling of electrons towards the luminescence centers - trivalent cerium ions Ce³+. To eliminate the negative influence of oxygen vacancies, ions of the second group, non-isovalently substituting gadolinium Gd ions, are additionally introduced into the crystal. With this non-covalent substitution, a deep electron capture center is formed in the garnet crystal matrix, which ensures rapid re-capture of captured carriers from smaller levels, thereby preventing interaction by tunneling carriers from small traps to ions of cerium Ce³⁺ and gadolinium Gd³⁺. The electron captured by the deep level recombines along the non-radiative channel.

Patent document JP 2013043960 A, 04.03.2013 discloses a scintillation crystal of aluminum-lutetium garnet Lu3Al5O12 for registration of gamma-ray quanta. In its monocrystalline form, the crystal has a maximum density of 6.7 g/cm3 and an effective charge Z_{eff}=63, which provides effective registration of gamma-ray quanta in a wide range of energies. However, the scintillation output of such a material does not exceed 15,000 phot/MeV, which makes it unsuitable for spectrometric measurements of gamma-ray quanta in a wide range of energies.

An increase in the scintillation output in inorganic materials with garnet structure is achieved by replacing yttrium or lutetium ions with gadolinium ions (see, for example, US 9193903 B2, 24.11.2015 and JP 2014094996 A, 22.05.2014), and aluminum ions with a pair of ions: aluminum and gallium, with the compound doped with cerium ions. Single crystals of gadolinium-aluminum-gallium garnet with structural formula Gd₃Al₂Ga₃O₁₂ doped with cerium ions have a high scintillation output, density 6.67 g/cm, effective charge Z_{eff}=51 and provide high energy resolution (see, e.g., US 8969812 A1, 21.11.2013 and US 2016017223 A1, 21.01.2016). The disadvantage of the known scintillation crystal is the presence of slow components in scintillation and phosphorescence. The phosphorescence of the scintillation material provides additional loading of the photodetector, which can increase the dead time of the scintillation detector registration and degrade the signal-to-noise ratio and energy resolution.

The proportion of slow components in the kinetics of scintillation and the phosphorescence of scintillation material doped with cerium ions is significantly reduced by co-activation of the scintillation substance with divalent ions of Mg, Ca, Sr, Ba. The known scintillation materials of Gd₃Al₂Ga₃O₁₂ are doped with cerium ions and co-activated with magnesium Mg or calcium CA ions (see, e.g., US 20150353822 A1, 10.12.2015). However, additional co-activation with Mg or CA ions leads to a decrease in scintillation output. The decrease in the scintillation output is due to a decrease in the content of cerium ions in the trivalent state of Ce³⁺. E.g., with an increase of the content of magnesium ions to 0.4%, the scintillation output in a single crystal of Gd₃Al₂Ga₃O₁₂ is reduced to a half. Therefore, the disadvantage of the known scintillation material of Gd₃Al₂Ga₃O₁₂ doped with ions of cerium Ce³⁺ and co-activated with Mg or Ca, is a reduced scintillation output compared to the scintillation material of Gd₃Al₂Ga₃O₁₂ doped with cerium ions.

There is a known scintillation material in the form of aluminum-yttrium garnet of Y₃Al₅O₁₂ doped with ions of cerium Ce³⁺ for registration of gamma-ray quanta (WO 2006068130 A1, 29.06.2006). In its monocrystalline form, the material has a maximum density of 4.55 g/cm³ and an effective charge Z_{eff} = 32, which provides effective registration of low-energy gamma-ray quanta and electrons, but the material remains inefficient for use for registration of gamma rays with an energy of more than 500 keV used, for example, in positron emission tomographs. The scintillation output of such material does not exceed 20,000 phot/MeV, which, combined with a low Z_{eff}, makes it poorly suitable for spectrometric measurements of gamma-ray quanta in a wide range of energies.

The analysis of patent and scientific and engineering literature shows that there are currently no scintillation materials that would have an optimal set of parameters for solving the above problems. In the prior art, there is a need for scintillation materials that combine a high scintillation output in a wide temperature range from minus 50°C to plus 20°C, high efficiency of ionizing radiation registration and a short time of scintillation luminescence with a minimum level of afterglow of the material.

Scintillation properties of materials largely depend on the methods of their production. Luminescent and scintillation properties of materials obtained by different methods are far from identical. The observed differences in the optical properties of crystals are primarily associated with differences in the concentrations of the major types of defects in the garnet structure, which, for single crystals of garnet are vacancies of different types, including oxygen vacancies, as well as the redistribution of the main components in the garnet structure due to dissociative evaporation of its volatile components having high values of the saturated vapor pressure,
e.g., various suboxides of gallium Ga³⁺ or aluminum Al³⁺. Generation of such defects is an inevitable consequence of the high (∼2000°C) temperature of the growth of bulk garnet crystals from the melt. The concentration of such defects in garnet crystals doped with rare-earth ions is comparable to the concentration of dopant ions. When using gas media with different partial pressure of oxygen for growth of crystals, these also show significant differences in the concentrations of vacancy defects, primarily oxygen vacancies.

Within the framework of this application, the complex problem of obtaining such a single crystal with garnet structure for scintillation detectors is solved, which would allow to obtain the highest scintillation output in an extended temperature range from minus 50°C to plus 20°C, while maintaining the duration of the main component of the scintillation kinetics and the minimum level of afterglow. The problem of increasing the energy resolution in the registration of gamma-ray quanta is also solved.

In addition, the problem of developing a method for obtaining such oxide single crystals with garnet structure for modification of their scintillation and optical properties by being co-alloyed with titanium and Group 2 elements is solved.

The problem is solved based on the fact that a single crystal with garnet structure for scintillation detectors is a compound described by the formula ((Gd₁₋ᵣYᵣ)₁₋ₛ₋ₓMeₛCeₓ)_{3-z}Ga_{1-y-q}Al_{y}Ti_{q})_{5+z}O₁₂, where q is in the range from 0.00003 to 0.02; r is in the range from 0 to 1; x is in the range from 0.001 to 0.01; y is in the range from 0.2 to 0.6; z is in the range from -0.1 to 0.1; s is in the range from 0.0001 to 0.1, with Me denoting at least one element from a series including Mg, Ca, Sr, Ba.

In addition, the fluorescent component of a single crystal with garnet structure, when irradiated with gamma-ray quanta, generates radiation at a wavelength in the range of 490,650 nm. The light output at a temperature of 20°C is not less than 45000 phot/MeV. The light output at a temperature of minus 50°C is not less than 54,000 phot/MeV.

The fluorescent component is characterized by the time constant of the main component of scintillation kinetics, which is not more than 50 nsec.

Preferably, the proportion of scintillation photons in the main component of scintillation kinetics (the proportion of the main component) of scintillation kinetics is not less than 75%; and the level of phosphorescence after 100 sec is not more than 0.7%.

Preferably, the ratio "light output at minus 50°C / light output at 20°C" is not less than 1.2.

The problem set is solved in that a method of obtaining single crystals with garnet structure for scintillation detectors includes prior preparation of a charge of stoichiometric composition of a mixture of oxides of Gd, Y, Ga, Al, Ni, forming the crystalline matrix of garnet, compound of cerium Ce, titanium Ti and at least one of the additives taken from the series including Mg, Ca, Sr, Ba, and the subsequent growth of the prepared charge of single crystals by the Czochralski process in a shielding atmosphere based on argon or nitrogen, with addition of oxygen in a concentration taken from the range of 0.0001 to 5 vol. %.

Preferably, the doping cerium additive is introduced in the form of a compound taken from the following series: oxide, fluoride, chloride, and alloying titanium additive is introduced in the form of oxide.

It is expedient that after growing, the resulting single crystal composition is subjected to isothermal annealing either in air or in an inert gas atmosphere, or in vacuum at a temperature from the range of 500-950°C for a time interval taken from the range of 1 min to 100 hours.

The essence of the invention is explained by non-limiting examples of its implementation, as well as tables 1 and 2. Table 1 lists the main parameters of known scintillation materials.

**Table 1.**

| Material | Density, g/cm³ | Z_{eff}/photoabsorp tion coefficient at 511 keV, cm⁻¹/radiation length X0, cm | Scintillation output, phot/MeV | Time constants of scintillation kinetics, nsec | λₘₐₓ, nm |
|---|---|---|---|---|---|
| Gd₃Al₂Ga₂O₁₂:Ce | 6.67 | 50.6/0.12/1.61 | 46.000 | 80, 800 | 520 |
| (Gd-Y)₃(Al-Ga)₅O₁₂:Ce | 5.8 | 45/0.08/1.94 | 60.000 | 100, 600 | 560 |
| Y₃Al₅O₁₂:Ce | 4.55 | 32.6/0.017/3.28 | 11 000 | 70 | 550 |
| Lu₃A₁₅O₁₂:Ce | 6.7 | 62.9/0.205/1.41 | 14 000 | 100 | 520 |
| YAlO₃:Ce | 5.35 | 32/0.019/2.2 | 16 200 | 30 | 347 |
| (Y_{0,3} - Lu_{0,7}) AlO₃:Ce | 7.1 | 60/0.21/1.3 | 13 000 | 18/80/450 | 375 |
| Gd₂SiO₅:Ce | 6.71 | 59.4/0.175/1.36 | 12 500 | 60, 600 | 430 |
| Lu₂SiO₅:Ce | 7.4 | 66/0.28/1.1 | 27 000 | 40 | 420 |
| CdWO₄ | 7.9 | 64.2/06.262/1.2 | 19 700 | 2000 | 495 |
| PbWO₄ | 8.28 | 75.6/0.485/0.89 | 100 | 6 | 420 |
| Bi₃Ge₄O₁₂ | 7.13 | 75.2/0.336/1.12 | 8200 | 300 | 505 |

Table 2 shows the compositions and characteristics of experimental samples of scintillation crystals in accordance with this application.

These single crystals with a garnet structure of the claimed formula containing a group of co-alloying admixtures for modification of its scintillation and optical properties are obtained by growing from a melt by Czochralski process according to the claimed method. This method involves loading a pre-synthesized charge into a crucible, the composition of the charge corresponding to the composition of the compound described by the formula ((Gd₁₋ᵣYr)₁₋ₛ₋ₓMeₛCeₓ)_{3-z}Ga_{1-y-q}Al_{y}Ti_{q})_{5+z}O₁₂, where q is in the range from 0.00003 to 0.02; r is in the range from 0 to 1; x is in the range from 0.001 to 0.01; y is in the range from 0.2 to 0.6; z is in the range from -0.1 to 0.1; s is in the range from 0.0001 to 0.1, wherein Me denotes at least one element from the series including Mg, Ca, Sr, Ba, creating a shielding atmosphere, subsequent melting of the material, introducing a rotating seed oriented crystal into contact with the melt surface, pulling the oriented crystal out of the melt. A garnet crystal, which is the closest to the crystal being grown in terms of composition, is used as a seed oriented crystal.

For preparation of initial charge, initial components are used in the form of oxides or carbonates of initial purity not worse than 99.99%. The content of impurities in these oxides must be kept ti the minimum and must not exceed 1 ppm for any of the impurity elements. The pre-dried initial oxides or carbonates are weighed according to the chemical formula of the crystal being synthesized, thoroughly mixed and synthesized at a temperature of at least 1400°C for at least 8 hours. The resulting material is loaded into an iridium crucible and placed in the growth chamber of the plant for growing single crystals.

Thermal insulation ceramics are placed around the crucible in such a way as to provide thermal insulation of the crucible and optimal temperature conditions for the growth and preservation of the grown single crystal. Besides, a seed holder with a pre-oriented seed crystal made of gadolinium-aluminum-gallium garnet is fixed to the upper working rod of the crystal growing plant. The plant is then closed and evacuated, followed by introduction of a shielding atmosphere based on argon or nitrogen with a slight addition of oxygen in a concentration from 0.0001 to 5 vol. %. After that, heating is carried out at a predetermined rate to the melting of the initial charge, homogenization of the melt by exposing the same for a certain time from 1 min to several hours, followed by seeding. Seeding is the process of contact of the seed crystal with the surface of the melt.

Meanwhile, the seed crystal rotates with a frequency from the range of 5...30 min⁻¹. After seeding, the upper working rod begins to move upwards at a certain speed from the range of 0.1-5 mm/hour. Then, in accordance with a specified growing program, a single crystal is formed, which, upon reaching a certain weight, is separated from the melt either by accelerated movement of the upper working rod, or by additional heating of the melt. The grown single crystal is cooled down to room temperature at a rate from the range of 10... 100 degrees per hour.

The resulting crystal is annealed in air, either in an inert gas atmosphere or in vacuum at a temperature from the range of 500-950°C for a time interval of 1 min to 100 hours.
Example 1. To grow a single crystal by the Czochralski process, an initial charge was used corresponding to the following composition: Gd_{2,9681}Ce_{0,03}Mg_{0,0019}Ga_{2,9998}Al₂Ti_{0,0002}O₁₂ and synthesized from a mixture of oxides Gd₂O₃, Ga₂O₃, Al₂O₃, CeO₂, TiO₂, MgO.
Example 2. To grow a single crystal by the Czochralski process, an initial charge was used corresponding to the following composition: Gd_{2,74}Ce_{0,03}Mg_{0,23}Ga_{2,903}Al₂Ti_{0,097}O₁₂ and synthesized from a mixture of oxides Gd₂O₃, Ga₂O₃, Al₂O₃, CeO₂, TiO₂, MgO.
Example 3. To grow a single crystal by the Czochralski process, an initial charge was used corresponding to the following composition: Gd_{2,9688}Ce_{0,03}Ca_{0,0012}Ga_{2,9998}Al₂Ti_{0,0002}O₁₂ and synthesized from a mixture of oxides Gd₂O₃, Ga₂O₃, Al₂O₃, CeO₂, TiO₂ and calcium carbonate CaCO₃.
Example 4. To grow a single crystal by the Czochralski process, an initial charge was used corresponding to the following composition: Gd_{2,74}Ce_{0,03}Ca_{0,23}Ga_{2,903}Al₂Ti_{0,097}O₁₂ and synthesized from a mixture of oxides Gd₂O₃, Ga₂O₃, Al₂O₃, CeO₂, TiO₂ and calcium carbonate CaCO₃.
Example 5. To grow a single crystal by the Czochralski process, an initial charge was used corresponding to the following composition: Gd_{2,9695}Ce_{0,03}Sr_{0,0005}Ga_{2,9998}Al₂Ti_{0,0002}O₁₂ and synthesized from a mixture of oxides Gd₂O₃, Ga₂O₃, Al₂O₃, CeO₂, TiO₂ and strontium carbonate SrCO₃.
Example 6. To grow a single crystal by the Czochralski process, an initial charge was used corresponding to the following composition: Gd_{2,86}Ce_{0,03}Sr_{0,11}Ga_{2,903}Al₂Ti_{0,097}O₁₂ and synthesized from a mixture of oxides Gd₂O₃, Ga₂O₃, Al₂O₃, CeO₂, TiO₂ and strontium carbonate SrCO₃.
Example 7. To grow a single crystal by the Czochralski process, an initial charge was used corresponding to the following composition: Gd_{2,9697}Ce_{0,03}Ba_{0,0003}Ca_{2,9998}Al₂Ti_{0,0002}O₁₂ and synthesized from a mixture of oxides Gd₂O₃, Ga₂O₃, Al₂O₃, CeO₂, TiO₂ and barium carbonate BaCO₃.
Example 8. To grow a single crystal by the Czochralski process, an initial charge was used corresponding to the following composition: Gd_{2,902}Ce_{0,03}Ba_{0,068}Ga_{2,903}Al₂Ti_{0,097}O₁₂ and synthesized from a mixture of oxides Gd₂O₃, Ga₂O₃, Al₂O₃, CeO₂, TiO₂ and barium carbonate BaCO₃.
Example 9. To grow a single crystal by the Czochralski process, an initial charge was used corresponding to the following composition: Gd_{2,9888}Ce_{0,01}Mg_{0,0012}Ga_{2,9998}Al₂Ti_{0,0002}O₁₂ and synthesized from a mixture of oxides Gd₂O₃, Al₂O₃, CeO₂, TiO₂, MgO.
Example 10. To grow a single crystal by the Czochralski process, an initial charge was used corresponding to the following composition: Gd_{2,968}Ce_{0,03}Mg_{0,002}Ga_{3,9998}Al₁Ti_{0,0002}O₁₂ and synthesized from a mixture of oxides Gd₂O₃, Al₂O₃, CeO₂, TiO₂, MgO.
Example 11. To grow a single crystal by the Czochralski process, an initial charge was used corresponding to the following composition: Gd_{2,9682}Ce_{0,03}Mg_{0,0018}Ga_{1,9998}Al₃Ti_{0,0002}O₁₂ and synthesized from a mixture of oxides Gd₂O₃, Ga₂O₃, Al₂O₃, CeO₂, TiO₂, MgO.
Example 12. To grow a single crystal by the Czochralski process, an initial charge was used corresponding to the following composition: Y_{2,9685}Ce_{0,03}Mg_{0,0015}Ga_{2,99985}Al₂Ti_{0,00015}O₁₂ and synthesized from a mixture of oxides Y₂O₃, Ga₂O₃, Al₂O₃, CeO₂, TiO₂, MgO.
Example 13. To grow a single crystal by the Czochralski process, an initial charge was used corresponding to the following composition: Gd_{2,8681}Y_{0,1}Ce_{0,03}Mg_{0,0019}Ga_{2,9998}Al₂Ti_{0,0002}O₁₂ and synthesized from a mixture of oxides Y₂O₃, Ga₂O₃, Al₂O₃, CeO₂, TiO₂, MgO.
Example 14. To grow a single crystal by the Czochralski process, an initial charge was used corresponding to the following composition: Gd_{2,906}Ce_{0,03}Mg_{0,064}Ga_{2,9956}Al₂Ti_{0,0044}O₁₂ and synthesized from a mixture of oxides Gd₂O₃, Ga₂O₃, Al₂O₃, CeO₂, TiO₂, MgO.
Example 15. To grow a single crystal by the Czochralski process, an initial charge was used corresponding to the following composition: Gd_{2,922}Ce_{0,03}Mg_{0,048}Ga_{2,9968}Al₂Ti_{0,0032}O₁₂ and synthesized from a mixture of oxides Gd₂O₃, Ga₂O₃, Al₂O₃, CeO₂, TiO₂, MgO.
Example 16. To grow a single crystal by the Czochralski process, an initial charge was used corresponding to the following composition: Gd_{2,952}Ce_{0,01}Mg_{0,038}Ga_{2,5975}Al_{2,4}Ti_{0,0025}O₁₂ and synthesized from a mixture of oxides Gd₂O₃, Ga₂O₃, Al₂O₃, CeO₂, TiO₂, MgO.
Example 17. To grow a single crystal by the Czochralski process, an initial charge was used corresponding to the following composition: Gd_{2,824}Y_{0,1}Ce_{0,03}Mg_{0,046}Ga_{2,9972}Al₂Ti_{0,0028}O₁₂ and synthesized from a mixture of oxides Gd₂O₃, Y₂O₃, Ga₂O₃, Al₂O₃, CeO₂, TiO₂, MgO.

Samples for measurements in the form of disks with a diameter of 25 mm and a thickness of 7 mm were made of grown single crystals.

**Table 2.**

| Scintillation substance in monocrystalline form | | Scintillation output at 20°C/-45°C, phot/MeV | Duration of the main component of scintillation kinetics, nsec | Proportion of the main component of scintillation kinetics, % | Afterglow level after 100 sec, % |
|---|---|---|---|---|---|
| 1 | Gd_{2.9681}Ce_{0.03}Mg_{0.0019}Ga_{2.9998}Al₂Ti_{0.0002}O₁₂ | 38000/45000 | 49 | 78 | 0.69 |
| 2 | Gd_{2.74}Ce_{0.03}Mg_{0.23}Ga_{2.903}Al₂Ti_{0.097}O₁₂ | 28000/38000 | 40 | 88 | 0.49 |
| 3 | Gd_{2.9688}Ce_{0.03}Ca_{0.0012}Ga_{2.9998}Al₂Ti_{0.0002}O₁₂ | 39000/45500 | 49 | 78 | 0.69 |
| 4 | Gd_{2.74}Ce_{0.03}Ca_{0.23}Ga_{2.903}Al₂Ti_{0.097}O₁₂ | 24000/31000 | 42 | 82 | 0.57 |
| 5 | Gd_{2.9695}Ce_{0.03}Sr_{0.0005}Ga_{2.9998}Al₂Ti_{0.0002}O₁₂ | 40000/44200 | 50 | 76 | 0.68 |
| 6 | Gd_{2.86}Ce_{0.03}Sr_{0.11}Ga_{2.903}Al₂Ti_{0.097}O₁₂ | 32000/36800 | 48 | 76 | 0.67 |
| 7 | Gd_{2.9697}Ce_{0.03}Ba_{0.0003}Ga_{2.9998}Al₂Ti_{0.0002}O₁₂ | 40200/44950 | 47 | 76 | 0.48 |
| 8 | Gd_{2.902}Ce_{0.03}Ba_{0.068}Ga_{2.903}Al₂Ti_{0.097}O₁₂ | 22000/28700 | 37 | 86 | 0.44 |
| 9 | Gd_{2.9888}Ce_{0.01}Mg_{0.0012}Ga_{2.9998}Al₂Ti_{0.0002}O₁₂ | 39000/46200 | 49 | 75 | 0.62 |
| 10 | Gd_{2.968}Ce_{0.03}Mg_{0.002}Ga_{3.9998}Al₁Ti_{0.0002}O₁₂ | 18000/21000 | 36 | 77 | 0.39 |
| 11 | Gd_{2.9682}Ce_{0.03}Mg_{0.0018}Ga_{1.9998}Al₃Ti_{0.0002}O₁₂ | 29200/36400 | 49 | 75 | 0.62 |
| 12 | Y_{2.9685}Ce_{0.03}Mg_{0.0015}Ga_{2.99985}Al₂Ti_{0.00015}O₁₂ | 33200/41500 | 49 | 75 | 0.62 |
| 13 | Gd_{2.8681}Y_{0.1}Ce_{0.03}Mg_{0.0019}Ga_{2.9998}Al₂Ti_{0.0002}O₁₂ | 44000/48340 | 49 | 80 | 0.71 |
| 14 | Gd_{2.906}Ce_{0.03}Mg_{0.064}Ga_{2.9956}Al₂Ti_{0.0044}O₁₂ | 39800/46300 | 47 | 84 | 0.44 |
| 15 | Gd_{2.922}Ce_{0.03}Mg_{0.048}Ga_{2.9968}Al₂Ti_{0.0032}O₁₂ | 46000/55500 | 44 | 88 | 0.67 |
| 16 | Gd_{2.952}Ce_{0.01}Mg_{0.038}Ga_{2.5975}Al_{2.4}Ti_{0.0025}O₁₂ | 41000/49000 | 46 | 85 | 0.55 |
| 17 | Gd_{2.824}Y_{0.1}Ce_{0.03}Mg_{0.046}Ga_{2.9972}Al₂Ti_{0.0028}O₁₂ | 43000/51800 | 48 | 83 | 0.70 |

Measurements of scintillation output were carried out by the standard gamma spectroscopy method. The samples were mounted on a PHILIPS XP2020 photoelectronic multiplier through an optical immersion lubricant, covered with a reflector and irradiated with a gamma-ray source Cs-137 with a gamma-ray quanta energy of 662 keV. Amplitude spectra were accumulated in a multichannel amplitude analyzer. The scintillation output of samples relative to each other was determined as the ratio of positions of peaks of total absorption of gamma-ray quanta at 662 keV on the scale of the amplitude analyzer.

Measurements of scintillation kinetics were carried out by the delayed coincidence method. For the measurements, we used a measuring stand on the basis of a source of annihilation gamma-ray quanta Na-22, a two-channel measurement plant with a "start" channel based on a CsF scintillation crystal and a photoelectronic multiplier PHILIPS XP2020 and with a "stop" channel based on photoelectric multiplier PHILIPS XP2020Q. Timing bound to signals of photoelectronic multipliers was exercised by two tracking-threshold, signals from which entered a time-amplitude converter that converts the difference in the arrival times of the start and stop signals into an output voltage pulse with an amplitude proportional to this difference, which then enters the multi-channel amplitude analyzer. The measured spectra of scintillation kinetics were processed in the software package ROOT V. 5.26, the time constants of the main component of luminescence and its weight (fraction) in the scintillation kinetics were determined.

Afterglow was measured by a method similar to that described in [K. Kamada, et al., Alkali earth co-doping effects on luminescence and scintillation properties of Ce doped Gd3A12Ga3O12 scintillator, Opt. Mater. (Amst). 41 (2015) 63-66. doi: 10.1016 / j. optmat. 2014.10.008]. The measurements were carried out in the photon counting mode by measuring the counting speed from the PHILIPS XP2020 photoelectronic multiplier after: a) 100 sec after termination of irradiation of the sample with an x-ray source for 15 minutes Sa, b) measuring the counting rate immediately before the termination of irradiation of the sample Sb, and c) measuring the "dark" counting rate with no sample mounted on the photoelectronic multiplier Sc. The samples were mounted on a photoelectronic multiplier through an optical diaphragm with a diameter of 1 mm to reduce the maximum counting speed and prevent the passage of pulses in determining the counting rate during irradiation of the sample. The counting rate was measured using a digital frequency meter. The discrimination threshold of the frequency meter was set so low as to capture most of the samples in the single-electron peak of the photoelectronic multiplier, but at the same time to avoid recording low-amplitude electronic noise. The phosphorescence level was determined as the ratio of counting rates expressed as percentage (Sa-Sc)/(Sb-Sc).

The use of the present invention makes it possible to obtain a single crystal with garnet structure for scintillation detectors with garnet structure having the following characteristics in the temperature range from minus 50°C to plus 20°C:
- Light output at T 20°C, not less than 45,000 phot/MeV;
- Light output at T minus 50°C, not less than 54,000 phot/MeV;
- Duration of the main component of scintillation kinetics - no more than 50 nsec;
- The share of the main component of scintillation kinetics - not less than 75%;
- Phosphorescence level after 100 sec, % - not more than 0.7%;
Ratio (light output at T minus 50°C / light output at T 20°C) - not less than 1.2.

The advantages of the present invention are provided by the fact that as a result of co-activation with titanium ions, the scintillation output increases in a wide temperature range from +20°C to -50°C and, as a consequence, the energy resolution at registration of gamma-ray quanta is improved. This makes it possible to expand the possibilities of using scintillation material with various photodetectors, for example, silicon photomultipliers, which achieve the minimum values of noise characteristics due to cooling.

## Claims

1. A single crystal with garnet structure for scintillation detectors, which is a compound described by the formula ((Gd₁₋ᵣYᵣ)₁₋ₛ₋ₓMeₛCeₓ)_{3-z}(Ga_{1-y-q}Al_{y}Ti_{q})_{5+z}O₁₂, where q is in the range from 0.00003 to 0.02; r is in the range from 0 to 1; x is in the range from 0.001 to 0.01; y is in the range from 0.2 to 0.6; z is in the range from -0.1 to 0.1; s is in the range from 0.0001 to 0.1, with Me denoting at least one element from the series including Mg, Ca, Sr, Ba.

2. The single crystal with garnet structure for scintillation detectors as per claim 1, **characterized in that,** with the above compound irradiated with gamma-ray quanta, the fluorescent component generates radiation at a wavelength in the range of 490-650 nm.

3. The single crystal with garnet structure for scintillation detectors as per claim 1, **characterized in that** the light output at a temperature of 20°C is not less than 45,000 phot/MeV.

4. The single crystal with garnet structure for scintillation detectors as per claim 1, **characterized in that** the light output at irradiation with a gamma-ray source Cs-137 with a gamma-ray quanta energy of 662 keV at a temperature of minus 50°C is at least 54,000 phot/MeV.

5. The single crystal with garnet structure for scintillation detectors as per claim 1, **characterized in that** the duration of the main component of scintillation kinetics is not more than 50 nsec.

6. The single crystal with garnet structure for scintillation detectors as per claim 1, **characterized in that** the proportion of the main component of scintillation kinetics is not less than 75%; and the phosphorescence level after 100 sec - not more than 0.7%.

7. The single crystal with garnet structure for scintillation detectors as per claim 1, **characterized in that** the ratio of the value of the light output of the single crystal at a temperature of minus 50°C to the value of the light output of the single crystal at a temperature of plus 20°C is not less than 1.2.

8. A method for producing single crystals with garnet structure for scintillation detectors as per claim 1 comprising preliminary preparation of a charge of stoichiometric composition in accordance with the chemical formula of the compound according to claim 1 from a mixture of oxides of Gd, Y, Ga, Al, Ti, Mg, introduction of cerium in the form of a compound taken from a series including: oxide, or fluoride, or chloride; Ba, or Sr, or Ca in the form of carbonate, and subsequent growing of single crystals from the resulting charge by the Czochralski process.

9. The method as per claim 8 **characterized in that** growing of single crystals by the Czochralski process is carried out in a shielding atmosphere based on argon or nitrogen with addition of oxygen in a concentration from the range of 0.0001 to 5 vol. %.

10. The method as per claim 8 **characterized in that** the grown single crystal is subjected to isothermal annealing at a temperature from the range of 500-950°C for a time taken from the range of 1 min to 100 hours, either in air, in an inert gas atmosphere, or in vacuum.
